Europäisches Patentamt

European Patent Office

Office européen des brevets

(11) Publication number: **0 471 350 A2**

# EUROPEAN PATENT APPLICATION

(21) Application number: **91113596.0**

(22) Date of filing: **13.08.91**

(51) Int. Cl.⁵: **G01R 1/067**

(30) Priority: **14.08.90 DE 4025764**

(43) Date of publication of application:
**19.02.92 Bulletin 92/08**

(84) Designated Contracting States:
**AT BE CH DE DK ES FR GB GR IT LI LU NL SE**

(71) Applicant: **Bio-Photonics, Inc.**
**10641 First Street East**
**Treasure Island Florida 33706(US)**

(72) Inventor: **Rubin, Leonid Borisovich, Prof.**
**Lomonossovsky Prospect 14/499**
**SU-117296 Moscow(SU)**
Inventor: **Untila, Gennady Grigorevich**
**Zelenograd, Korp. 316, kv. 28**
**SU-103482 Moscow(SU)**

(74) Representative: **Ebbinghaus, Dieter et al**
**v. FÜNER, EBBINGHAUS, FINCK**
**Patentanwälte European Patent Attorneys**
**Mariahilfplatz 2 & 3**
**W-8000 München 90(DE)**

(54) **Measuring electrode.**

(57) A measuring electrode (1) for making an electric contact with an object, in particular a semiconductor body (2), comprises an electrically conductive liquid, said liquid contacting the surface of the object via capillaries of a capillary material, said capillaries debouching at said surface. According to the invention the whole electrode body consists of capillary material, said material being fillable by an electrically conductive liquid, with the electrically conductive liquid being retained in the electrode body and fed onto the surface only by the capillary forces of said capillary material. The described construction results in easy handling of the device and accurate and repeatable measurements.

FIG.1

The invention relates to a device for making a permanent electric contact with an object, preferably a semiconductor body, and in particular to a measuring electrode for such a device, which makes the contact with the object by means of an electrically conductive liquid, which contacts the surface of the object via capillaries debouching at said surface.

Such a measuring electrode is known from US-A-3 975 681.

As a result of the desire to permanently increase the degree of integration in the manufacture of microelectronic components, working processes get ever more difficult and ever more complex, and costly equipment is required. This leads to an increasing need of control processes and devices to sort defective products after each working cycle.

Currently a wide variety of processes is used to determine the properties of materials, including X-ray-, electrone-, and ion-spectroscopy as well as optical spectroscopy and electrical processes (Technology of Circuits With a Very High Degree of Integration, Moscow, publishing house Mir, 1986, vol. 1, pages 247 to 254, vol. 2, pages 271 to 327). However, in manufacture only a few of them can be used, as control processes and devices suitable for this purpose have to meet a whole range of requirements. Above all, they must not attack the products and should be reliable and cheap.

Therefore, in manufacture only a limited number of control processes and devices is used, including especially processes based on carrying out electric measurements, as e.g. the four-probe-process to determine the surface resistivity, the Volt-Farad-process to determine the doping concentration profile, etc. (Technology of Circuits With a Very High Degree of Integration, Moscow, publishing house Mir, 1986, vol. 1, pages 247 to 254). As the results of electric measurements depend on the contact surface, the size of the area and its repeatability is one of the basic parameters, characterising the accuracy of the processes. Known devices either use metal pins which are pressed against the semiconductor to make an electric contact with the semiconductor or metallic contacts are provided by vapour deposition. However, the pin contacts damage the surface of the semiconductor. In addition, some characteristics of contacts of that kind cannot be calculated accurately, due to detrition of the pin and a certain roughness of the surface of the semiconductor. Vapour deposition of contacts is very time-consuming and these contacts have to be subsequently removed.

The electrode known from the already mentioned US-A-3 975 681 consists of a tube made of a rigid electrically insulating material and a spherical cap arranged at one end of said tube, made of non-rigid, preferably flexible, electrically insulating capillary material. The interior of tube and cap serve to take up a free electrolyte.

The known electrode is difficult to handle, as leaking of the electrically conductive liquid can only be prevented if low pressure exists above the liquid column in the tube. A substantial disadvantage of the known electrode consists in the fact that it does not permit to obtain repeatable results, since deforming the cap by applying pressure to the electrode is precondition for its function. However, this pressure is not controllable and would be controllable only with great efforts. In addition, the height of the column of the liquid contained in the electrode and the changing pressure above the liquid are acting upon the leaking liquid.

Finally, the known electrode can be used only in upright position above the test sample.

From US-A-3 794 912 a device is known for making a not attakking permanent electric contact with a semiconductor body for carrying out electric measurements by means of an electrode, said electrode being filled with an electrically conductive liquid and in permanent electric contact with the semiconductor body. This device comprises a dielectric block, on the upper surface of which the semiconductor body to be controlled is placed. The dielectric block comprises one or more ducts debouching into a contact surface to be brought in contact with the semiconductor body. These ducts, which are constituting an electrode, are filled with an electrically conductive liquid, said liquid under pressure reaching the contact place with the semiconductor body via the orifices of the ducts. In this device mercury is used as electrically conductive liquid. Though a mercury probe works reliably and does not cause mechanical damage on the surface of the semiconductor, it is not free from substantial disadvantages. The use of mercury is undesirable not only for ecological reasons but also because it results in an inadmissible pollution of the semiconductor body with mercury atoms.

Furthermore this device has the disadvantage that in general, i.e. when any electrically conductive liquid is used, no electric contact with the semiconductor body with accurately defined area can be made, because an air gap between the semiconductor body and the dielectric block on which the semiconductor is placed is indispensable precondition for the operating ability of such a device. Through this gap the air from the duct in the dielectric block is removed when the duct is filled with an electrically conductive liquid. If the semiconductor body and the dielectric block are in close contact with one another, i.e. if no gap between them is provided, the air from the opening in the dielectric block is not removed, but obstructs the penetration of electrically conductive liquid into the opening of the dielectric block, intended to make an electric contact.

However, the presence of a gap between the dielectric block and the semiconductor body not only allows the air to leave the duct/the electrode but also permits the penetration of electrically conductive liquid into said gap. Said penetration is stimulated by, firstly, the fact that the electrically conductive liquid reaches the opening of the dielectric block by means of a pressurized gas and, secondly, the fact that the gap itself constitutes a capillary tube, and when the surface of the dielectric block or the semiconductor body is wetted with the electrically conductive liquid, said tube absorbs the liquid. Thus the contact area diffuses and the size of the contact surface changes uncontrollably. Only if the electrically conductive liquid does not wet the surface of the dielectric block or the semiconductor body, as is the case for example with mercury, is there any possibility of maintaining the predetermined contact surface by a complicated control of the gas feeding pressure. This conclusion is also confirmed by the fact that the only electrically conductive liquid mentioned in the US-patent is just mercury. It has to be remarked that in the present case a continuous contact surface can only be maintained by the gas pressure, if the surface tension of the electrically conductive liquid remains constant. This in turn requires a purity of the surface of the electrically conductive liquid which nearly exactly equals that of a mono-molecular layer, since already fractions of foreign atoms (foreign molecules) substantially alter the surface tension of the electrically conductive liquid and result in an uncontrollable alteration of the contact surface. Thus, if the electrically conductive liquid for example wets the surface of the semiconductor body (as is the case with aqueous electrolytes and a hydrophilic silicon disk), it is not possible to get contact surfaces of a predetermined size. Therefore this device cannot be used in equipment which requires an accurately predetermined contact surface for performing electric measurements.

The underlying problem of the invention is to create a device for measuring the electric parameters of an object, preferably made of semiconductor material, and in particular a measuring electrode for such a device, which guarantees a contact place of the electrode with the object to be controlled with an accurately defined area without external pressure on the electrically conductive liquid, i.e. to create a self-adjusting control system and to do without mercury.

According to the invention, this problem is solved by making the whole electrode body of capillary material, the capillary material being fillable by an electrically conductive liquid, with the electrically conductive liquid being retained in the electrode body only by the capillary forces of the capillary material in the electrode body.

In other words, practically the whole electrode body consists of capillary material and the electrically conductive liquid is practically exclusively contained in the capillary material. In this connection, the electrically conductive liquid and the capillary material have to be chosen, so that the liquid wets the capillary material and the object.

By the formation of the electrode according to the invention and corresponding choice of the electrically conductive liquid, it is possible to obtain a contact area of the electrically conductive liquid with the semiconductor body with an accurately defined surface area. This is achieved because the electrically conductive liquid penetrates into all capillary tubes of the electrode material and thus assumes the shape of the electrode. Thus, if the shape and the geometrical dimensions of the electrode, particularly the frontal area of the electrode, being in contact with the semiconductor body, are predetermined, the contact area can accurately be predetermined as well. In addition, if the electrode is made of a capillary material wettable by an electrically conductive liquid, no pressurized gas is needed to force the liquid to the surface of the semiconductor body, as this is effected by the capillarity of the electrode material, said capillarity conducting the electrically conductive liquid directly to the frontal area of the electrode being in contact with the semiconductor body. As further positive effect, the capillarity of the electrode material prevents diffusion of the liquid on the surface of the semiconductor body even if the liquid wets the surface of the body. If the wetting liquid starts diffusing on the surface of the semiconductor body, simultaneously empty capillary tubes are formed at the opposite end of the electrode. The capillarity at this end of the electrode will be correspondingly higher. This force balances the wetting forces of the liquid and the semiconductor body, thus guaranteeing continuity of the contact surface. Consequently these forces counterbalance each other and the diffusion stops. Between the semiconductor body and the electrode consequently a meniscus is formed, the size of which is determined by the design of the electrode and other parameters. This size is a stable, repeatable characteristic. An electrode made of capillary material is therefore self-adjusting, does not require additional external control, e.g. by means such as pressurized gas with fine adjustment of the pressure, and allows to make a contact between the electrically conductive liquid and the semiconductor body with accurately predetermined and repeatable contact surface. This does not only apply to an electrically conductive liquid and a semiconductor body which do not wet one another but also to an electrically conductive liquid wetting the semiconductor body.

The electrode must be made of capillary material, which is chemically neutral with respect to the semiconductor material to be controlled and to the electrically conductive liquid and has to meet some specific requirements, depending on its field of application. For example, if the electrode is used in microelectronics industry, it may not introduce compounds or elements such as copper, alkali metal ions, organic impurities etc. into the electrically conductive liquid. Further, the material has to be wettable by the electrically conductive liquid used in the electrode according to the invention, or else the liquid will not move in the capillaries.

Size and shape of the contact area are exclusively determined by the area of the electrode contacting the surface of the test sample. For this reason, the surface of the electrode that comes into contact with the test sample should preferably be flat, as in most cases the surface of the samples to be tested is also flat. In order to minimize the influence of fringe effects on the repeatability of the contact surface, the surface of the electrode that comes into contact with the sample has to be of clear-cut outline and sharp-edged.

Repeatability of the contact surface gets better with increasing rigidity of the capillary material, as in this case the electrode is only minimally deformed when being pressed to the sample and thus the amount of electrically conductive liquid leaking from the electrode is kept to a minimum. Only if the surface topography of the sample to be tested becomes more complex is it desirable to use an elastic capillary material at least in the area coming into contact with the sample.

Further to all that, the electrode can be used in any position, for example also "upside-down".

Preferably the measuring electrode is at least at the contacting end made of a porous capillary material, thus allowing the individual capillary tubes to communicate with one another via the open pores, as this leads to a uniform distribution of the liquid over the surface and thus an increase in operational ability of the device. If, e.g., a gas bubble incidentally penetrates into a capillary tube, it can be pushed through the open pores to the sides of the electrode. Otherwise penetration of a gas bubble can lead to an interruption of the electric circuit and the movement of the electrically conductive liquid in the capillary tubes, or the gas bubble can reach the contact area and cause an alteration of the contact surface. In addition, the use of porous capillary material allows the production of electrodes of any desired shape.

The electrode can be made of powdery material, e.g. sintered or compacted powder, of fibrous or felt material, foamed material or material with punctured capillary tubes etc. Glass, quartz, fluoroplastics, nitrocellulose, or cellulose etc. are used as electrode material.

If the measuring electrode is incorporated in a capsule or a bushing, interaction of the electrically conductive liquid with especially the atmosphere can be prevented. This is for example required if evaporation of the electrically conductive liquid at the surface and penetration of impurities into the electrically conductive liquid, which could later reach the surface of the semiconductor body, are to be prevented.

The capsule can be made of electrically conductive as well as of dielectric material. It can also consist of dielectric material coated with electrically conductive material or of electrically conductive material coated with dielectric material. In the preferred type the capsule consists of electrically conductive material or of dielectric material coated with electrically conductive material, as this permits electric contact of the external conductors of the measuring devices with the electrically conductive liquid by means of the capsule. The external conductors are connected to the electrically conductive material of the capsule, which in turn is connected to the electrically conductive liquid.

The material of the capsule has to be chemically neutral with respect to the material of the semiconductor body and the electrically conductive liquid, in order to obtain longer service life and a contact which does not attack or contaminate.

The material of the capsule may also not introduce components into the electrically conductive liquid, which are prohibited in the respective field of application of the device. Such components include in microelectronics copper, ions of alkali- and heavy metals and organic impurities.

The capsule can be made either of stiff or of flexible material or it can be composed of both materials. Using stiff material reduces the required mechanical properties of the electrode, as in this case the shape of the electrode is predetermined by the shape of the capsule. On the other hand, by using flexible material for the whole capsule or its components, the electrode can be flexibly pressed against the semiconductor body.

Preferably the electrode projects from the capsule in the contact area with the semiconductor body. This can prevent contact of the capsule with the semiconductor body, which could lead to an alteration of the contact surface or to contaminating or mechanically damaging the surface of the semiconductor body.

An electrode consisting of different capillary material is preferred, one part of which for example consists of porous material with certain mechanical properties, whereas the other part is made up of material with different properties. In a useful design the part of the electrode which is in direct contact with the semiconductor body consists of an elastic material and the other part of stiff material, so that the material of the electrode in the contact area can assume the topography of the surface of the semiconductor body.

The electrode can be arranged on top of the semiconductor body. Such an arrangement might be necessary because of service conditions, if, e.g., measurements are to be performed in a silicon disk bonded to a polishing machine.

The measuring device which uses the measuring electrode according to the invention is preferably designed in a way, that the electrode(s) touch the semiconductor body from beneath, as in this case the positive effect of the gravitational forces, which also prevents diffusion of the liquid on the surface of the semiconductor body, improves repeatability of the contact surface.

The device can comprise several electrodes. This is advantageous, because often measurements have to be carried out in several sections of the semiconductor body, and it is more convenient to use several electrodes for that purpose. If only one electrode is used, the device has to provide an additional element for shifting the electrode or the disk.

By using a block which comprises one or more electrodes, one electrode relative to the semiconductor body or several electrodes relative to one another can be arranged at the desired position. Particularly if several electrodes are used, the device has to ensure that all electrodes are simultaneously in contact with the semiconductor body.

The block preferably consists of a dielectric material, to guarantee an electrical insulation between the electrodes, if more than one electrode is used. An electrically conductive material can be used, if, e.g., only one electrode is used.

A preferred embodiment comprises an element of flexible, resilient material, which presses the electrode(s) against the semiconductor body. This is required to press all electrodes simultaneously against the semiconductor body, in case several electrodes are used. In particular, this element can be a component of the capsule. Resilient pressing against the semiconductor body also allows adjustment of the pressing force.

The device comprises a container for the electrically conductive liquid which is fed into the electrode, said electrode being in contact with the electrically conductive liquid in the container. This is necessary if the electrode is brought into contact with the semiconductor body more than once, as after each of these "contacts" part of the electrically conductive liquid might stick to the semiconductor body, leading to a decrease of liquid in the electrode. The electrode is automatically fed with the electrically conductive liquid from the container by means of the capillary forces in the porous material of the electrode. If a wetting fluid is used, the electrode may have to be lifted from the container during the measurement to prevent continous feeding of liquid.

If several electrodes are used, either each electrode is fed from an individual container, or all electrodes are supplied from a common container. In the latter case it is also useful to interrupt the contact of the electrodes with the container during the measurement to insulate the electrodes against one another and to improve repeatability of the contact surface.

When several electrodes are used, the frontal areas of the electrodes being in contact with the semiconductor body are of the same size to simplify the evaluation of the measuring results. This is also needed for studying the statistical characteristic curves of the measurable variables which can only be produced if the electrode surfaces are of the same size.

The electrodes comprise frontal areas being in contact with the semiconductor body, which are of the same size, if, for solving a given task, a distinction is to be made between measuring data proportional to the contact surface and measuring data not proportional to the contact surface.

The figures show examples of the measuring electrode according to the invention and the measuring device according to the invention,

Fig. 1    showing an electrode made up of porous capillary material being in contact with a semiconductor body,

Fig. 2    an electrode arranged on top of the semiconductor body,

Fig. 3    a device with several electrodes, said electrodes being arranged either above (Fig. 3a), under (Fig. 3b) or on both sides of the semiconductor body,

Fig. 4    an electrode in a capsule,

Fig. 5    several electrodes in capsules, fixed by means of a block,

Fig. 6    a first resilient type,

Fig. 7    a second resilient type,

Fig. 8    an electrode in contact with a container filled with an electrically conductive liquid,

Fig. 9    an electrode consisting of two parts,

Fig. 10    electrodes with frontal areas of the same size,

Fig. 11    electrodes with frontal areas of different sizes,

Fig. 12    a first type of connecting the electrodes to a measuring device,

Fig. 13    a second type of connecting the electrodes to a measuring device and

Fig. 14 a Volt-Farad characteristic curve, measured by means of the electrode according to the invention.

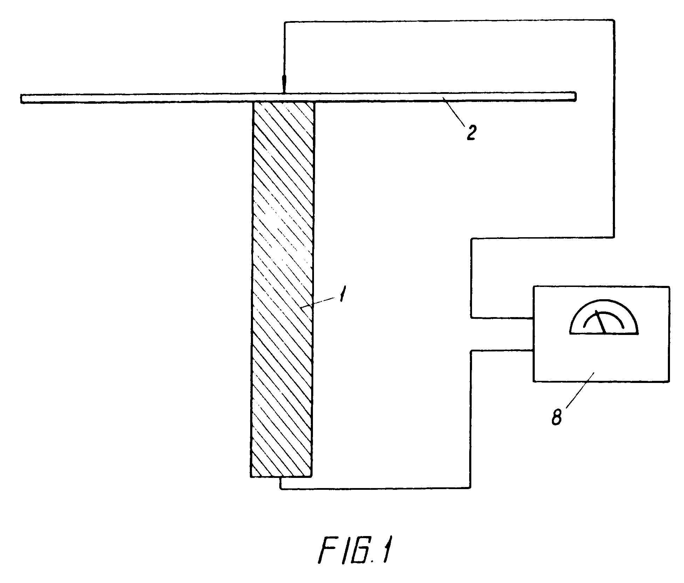

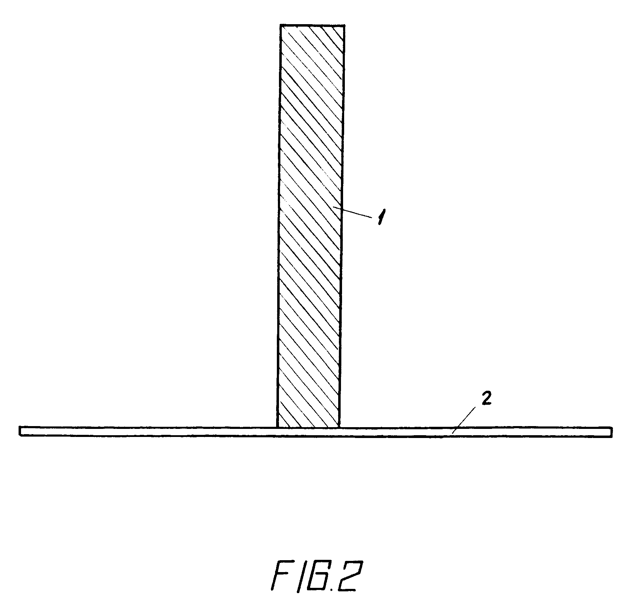

Fig. 1 shows a measuring device with a measuring electrode 1 of capillary material, positioned from beneath against the surface of a semiconductor body and connected to a measuring device 8.

The capillary material is wettable with an electrically conductive liquid. In this case the electrically conductive liquid is absorbed by the capillary tubes of electrode 1 under capillary action and completely fills the volume of electrode 1. Thereby the liquid material (the electrically conductive liquid) can be given the desired shape by predetermining the shape of electrode 1. In the contact area of electrode 1 with semiconductor body 2 an electric contact is made between the electrically conductive liquid and semiconductor body 2. By predetermining shape and size of the contact area between electrode 1 with semiconductor body 2, the desired shape and area of the electric contact with said body 2 can be obtained.

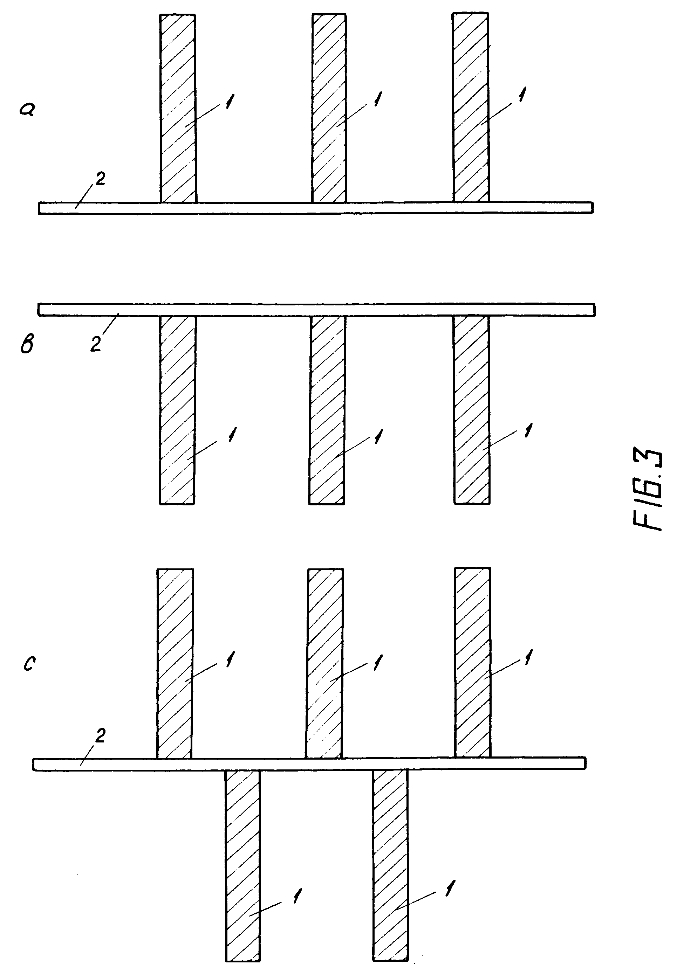

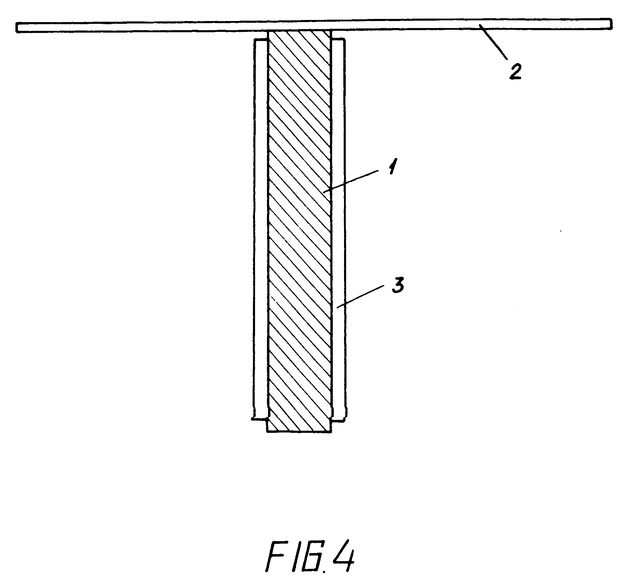

Electrode 1 can be arranged on top of semiconductor body 2 (Fig. 2). Such an arrangement might become necessary because of service conditions, if, e.g., measurements are to be performed in a silicon disk bonded to a polishing machine. Electrode 1 can be in contact with semiconductor body 2 at one side. However, in a preferred embodiment electrode 1 is in contact with semiconductor body 2 at said body's lower side (Fig. 1), as the advantageous effect of the gravitational forces reduces diffusion of the electrically conductive liquid on body 2, because the gravitational forces and also the capillary forces act in the opposite direction of the forces causing the diffusion of the liquid.

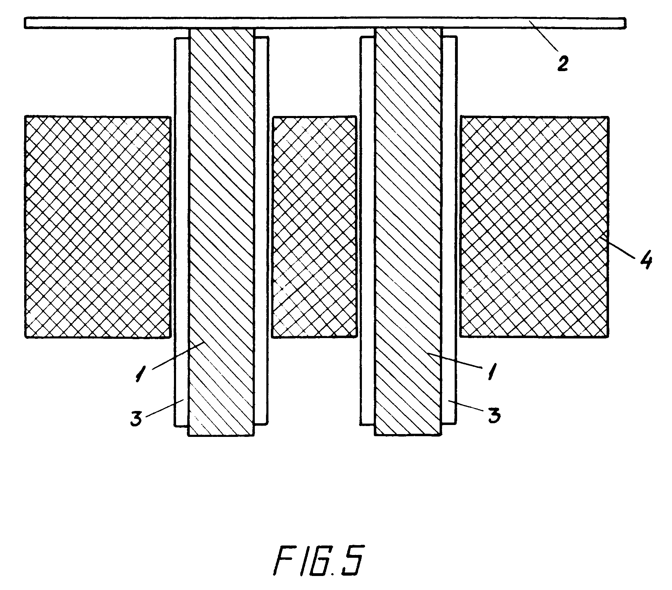

In order to solve certain tasks, the device comprises several electrodes 1 (Fig. 3). For example, if parameters of silicon disks are controlled, measurements are performed in 5, 9, 17 or more sections. Processes are known, which use even more contacts. Though measurements can also be performed with one electrode 1 in several sections of body 2, the process requires an additional shifting device and is much more time-consuming.

If the device comprises only one electrode 1, although at least two electric contacts were needed to perform electric measurements, an additional contact element, e.g. a pin contact with semiconductor body 2 were required. Some tasks can be solved successfully if two electrodes 1 are used as contacts. If several electrodes are used, said electrodes might be arranged either above (Fig. 3a), under (Fig. 3b) or on both sides of the semiconductor body. The electrodes can also be located on one or both sides of this body 2.

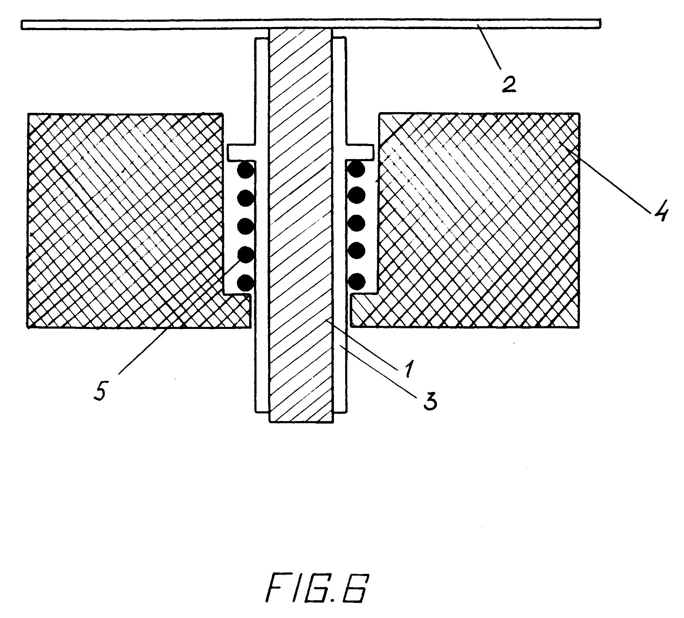

It is useful to have electrode 1 enclosed in a capsule 3 (Fig. 4).

Capsule 3 can either be made of stiff or of flexible material or be composed of both materials. Using stiff material reduces the required mechanical properties of the electrode 1, as in this case the shape of the electrode 1 is predetermined by the shape of the capsule 3. On the other hand, by using flexible material for the whole capsule 3 or its components, the electrode 1 can be flexibly pressed against the semiconductor body 2.

Preferably electrode 1 projects from the capsule 3 in the contact area with the semiconductor body 2 (Fig. 4), as this can prevent contact of the capsule 3 with the semiconductor body 2.

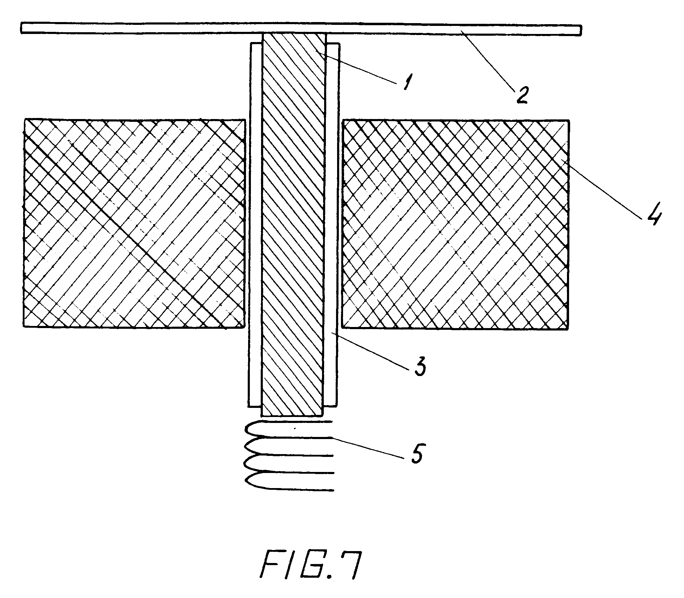

By using a block 4 (Fig. 5), which comprises one or more electrodes 1, one electrode 1 relative to the semiconductor body 2 or several electrodes 1 relative to one another can be arranged at the desired position. Particularly if several electrodes 1 are used, the device has to ensure that all electrodes 1 are simultaneously in contact with the semiconductor body 2.

The block 4 preferably consists of a dielectric material, to guarantee an electrical insulation between the electrodes 1, if more than one electrode is used. An electrically conductive material can be used for block 4, if, e.g., only one electrode 1 is used.

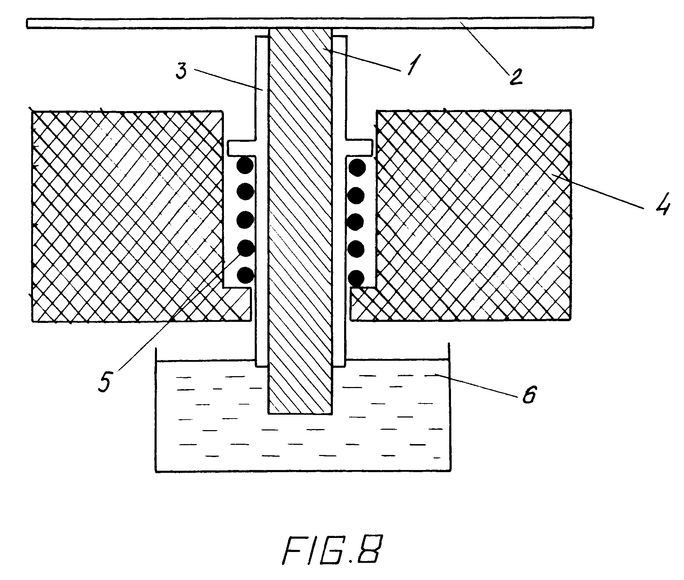

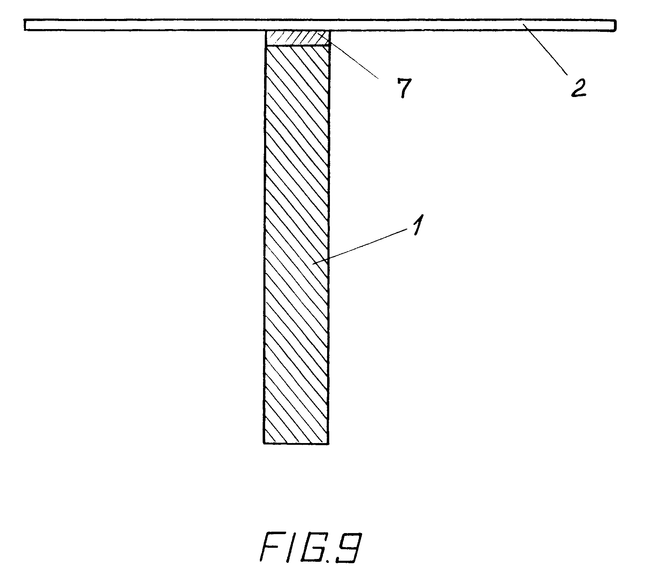

Figures 6 and 7 show devices comprising an element 5 comprising a flexible resilient material, e.g. a spring, which presses electrode 1 against semiconductor body 2. This ensures simultaneous contact when several electrodes 1 are used. This element 3 can particularly be a component of capsule 3.

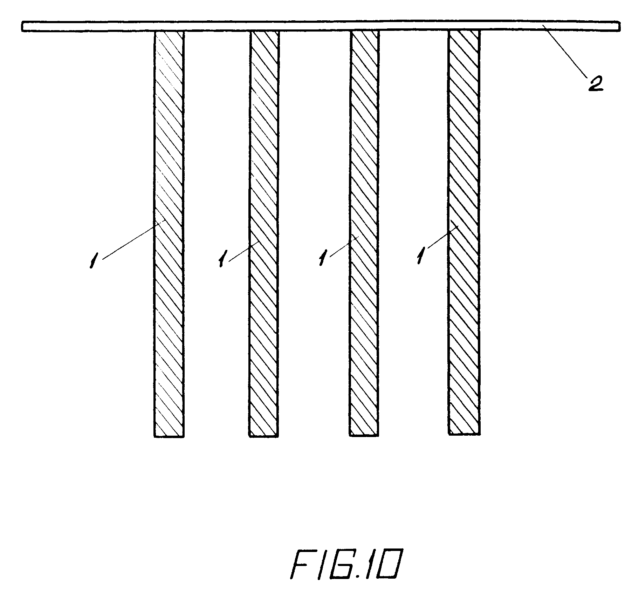

Fig. 9 shows an electrode 1 consisting of different materials, i.e. one part of the electrode consists for example of porous material with certain mechanical properties, whereas the other part is made up of material with different properties. In a useful design part 7 of the electrode which is in direct contact with the semiconductor body 2 consists of an elastic material and the other part of stiff material, so that the material of electrode 1 in the contact area can assume the topography of the surface of the semiconductor body 2.

Fig. 8 shows a device comprising a container 6 for the electrically conductive liquid which is fed into electrode 1, said electrode 1 being in contact with the electrically conductive liquid in container 6. This is necessary if elec-trode 1 is used for more than one measurement, as after each of these "contacts" between electrode 1 and semiconductor body 2 part of the electrically conductive liquid might stick to semiconductor body 2, leading to a decrease of liquid in electrode 1. It is useful to interrupt the contact between the electrically conductive liquid and electrode 1, as this creates capillary forces which prevent diffusion of the liquid on the surface of the semiconductor body. Electrode 1 is automatically fed with electrically conductive liquid from container 6 by means of said capillary forces in the capillary material of electrode 1.

Connection between electrodes and container is maintained by the arrangement of the electrodes relative to semiconductor body 2. The electrodes can be located above, under or at the side of said body.

If several electrodes 1 are used, either each electrode 1 is fed from an individual container 6, or all electrodes 1 are supplied from a common container 6. In the latter case it is also useful to interrupt the contact of electrodes 1 with container 6 during the measurement to insulate electrodes 1 against one another and to improve repeatability of the contact surface.

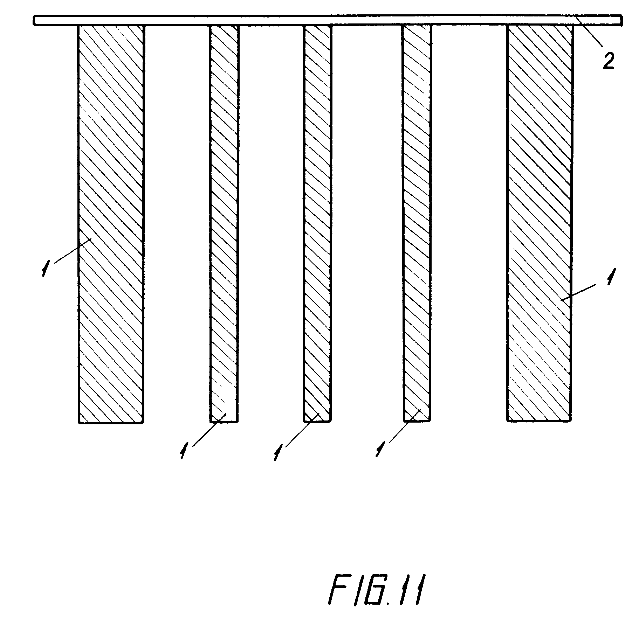

When several electrodes 1 are used, the frontal areas of the electrodes being in contact with semiconductor body 2 are of the same size (Fig. 10), to simplify the evaluation of the measuring results. This is also needed for studying the statistical characteristic curves of the measurable variables which can only be produced if the electrode surfaces are of the same size.

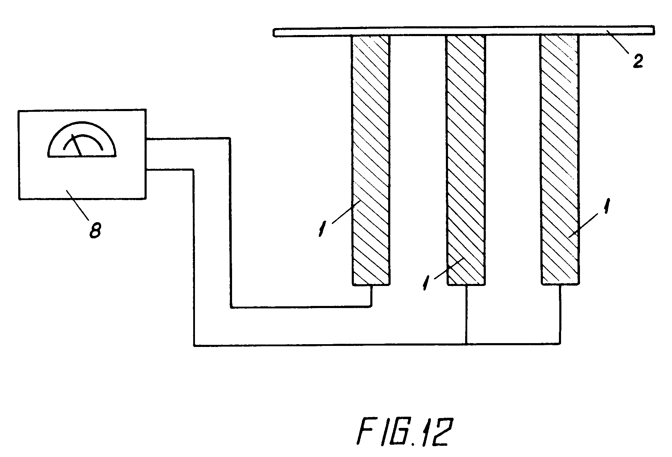

Electrodes 1 comprise frontal areas being in contact with the semiconductor body, which are of the same size (Fig. 11), if, for solving a given task, a distinction is to be made between measuring data proportional to the contact surface and measuring data not proportional to the contact surface.

Electrolytic solutions can be used as electrically conductive liquids. It is useful that the electrolytes consist of compounds or their solutions, which do not contain components that can contaminate or damage the semiconductor body or the material of electrode or capsule, as, e.g., aqueous solutions of HF, $NH_4OH$ etc. Selection of an electrolyte depends on the respective field of application of the device according to the invention. Water is preferably used, as water is a common material in microelectronics and ecologically harmless.

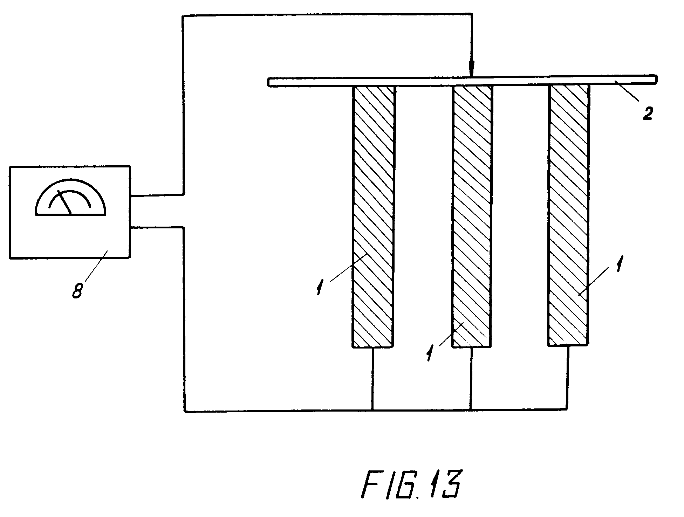

There are several possibilities to connect the device to measuring devices, depending on the respective task. Fig. 12 shows a design where one or more electrodes 1 are connected to one conductor and the other electrodes 1 to the other conductor. The electrodes 1 can be connected simultaneously to the conductor or one after another (Fig. 13). The electrodes are connected simultaneously to achieve a greater contact surface and one after another if independent measurements are to be performed in different sections of the disk.

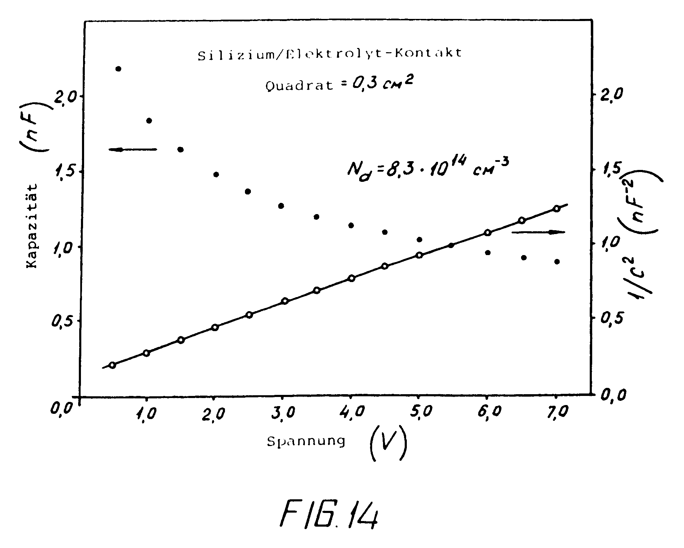

Fig. 14 shows the results of measurements of voltage-capacity curves at the border between silicon and the electrically conductive liquid. Water was used as electrically conductive liquid. The contact between the electrically conductive liquid and the silicon was made by means of an electrode 1, composed of two parts, the part being in direct contact with semiconductor 2 consisting of hydrophilic porous capillary material and the other part consisting of sintered quartz powder. The performed tests showed a high repeatability (not worse than 1 %) of the contact surface of the electrically conductive liquid with the semiconductor body.

## Claims

1. Measuring electrode (1) for making an electric contact with an object, in particular a semiconductor body (2), by means of an electrically conductive liquid, said liquid contacting the surface of the object via capillaries of a capillary material, said capillaries debouching at said surface, characterized in that the whole electrode body consists of capillary material, said material being fillable by an electrically conductive liquid, with the electrically conductive liquid being retained in the electrode body and fed onto the surface only by the capillary forces of said capillary material.

2. Measuring electrode as claimed in claim 1, characterized in that said electrode (1) consists at least at the end in contact with the object of capillary material with open pores.

3. Measuring electrode as claimed in claims 1 or 2, characterized in that said electrode (1) consists of powdery, fibrous, felted or foamed material.

4. Measuring electrode as claimed in claim 1, characterized in that the material which can be wetted by the electrically conductive liquid consists of glass, quartz, fluoroplastics, nitrocellulose or cellulose.

5. Measuring electrode as claimed in one of the previous claims , characterised in that said electrode (1) is located in a capsule (3).

6. Measuring electrode as claimed in claim 5, characterised in that the capsule (3) consists of an electrically conductive material.

7. Measuring electrode as claimed in claim 6, characterized in that the electrically conductive liquid of the capsule (3) is coated on the internal and/or external surface with a dielectric layer.

8. Measuring electrode as claimed in claim 5 characterized in that said capsule consists of dielectric material.

9. Measuring electrode as claimed in claim 8, characterized in that said dielectric material of the capsule (3) is coated on the internal and/or external surface with an electrically conductive liquid.

10. Measuring electrode as claimed in claim 5, characterized in that said electrode (1) projects in the contact area from said capsule (3).

11. Measuring electrode as claimed in any of the previous claims, characterized in that said electrode consists of different capillary materials.

12. Measuring electrode as claimed in any of the previous claims, characterized in that the electrically conductive liquid, consists of electrolytes, preferably water.

FIG.1

FIG.2

Q

1

1

1

2

B

2

1

1

1

C

2

1

1

1

1

1

FIG. 3

FIG.4

FIG.5

FIG.6

FIG.7

FIG.8

FIG.9

FIG.10

FIG.11

FIG.12

FIG.13

Silizium/Elektrolyt-Kontakt

Quadrat = $0,3 \ cm^2$

$N_d = 8,3 \cdot 10^{14} \ cm^{-3}$

FIG. 14